# EUROPEAN PATENT APPLICATION

(11) **EP 1 209 730 A2**
(43) Date of publication of application: **29.05.2002**
(21) Application number: 01309533.6
(22) Date of filing: 12.11.2001
(51) Int. Cl.: H01L 21/3205

(54) **High temperature electrode and barrier structure for FRAM and DRAM applications**

(30) Priority: 22.11.2000 US 721800
(71) Applicant: Sharp Kabushiki Kaisha, Osaka-shi, Osaka 545-8522 (JP)
(72) Inventor: Zhang, Fengyan, Vancouver, WA 98683 (US); Hsu, Sheng Teng, Camas, WA 98607 (US); Ying, Hong, San Jose, CA 95133 (US)
(74) Representative: Brown, Kenneth Richard

(57) **Abstract**

A semiconductor structure includes a substrate taken from the group of substrates consisting of silicon, polysilicon, silicon dioxide and silicon germanium; and an electrode, located above the substrate, which includes a layer of composition Ir-M-O, wherein M is take from the group of metals consisting of Ta, Ti, Nb, Al, Hf, Zr and V; wherein the semiconductor structure is constructed and arranged to withstand annealing at a temperature greater than or equal to 600°C without losing conductivity and integrity. A method of forming a semiconductor structure includes preparing a substrate taken from the group of substrates consisting of silicon, polysilicon, silicon dioxide and silicon germanium; depositing successive layers of materials including depositing an electrode layer of composition Ir-M-O, wherein M is taken from the group of metals consisting of Ta, Ti, Nb, Hf, Zr and V; and annealing the semiconductor structure at a temperature greater than or equal to 600°C.

## Description

### Field of the Invention

This invention relates to FeRAM and DRAM semiconductors, and specifically to the use of barrier layers and electrodes which remain stable during and after high-temperature annealing.

### Background of the Invention

FeRAM and DRAM semiconductors are susceptible to breakdown of intermediate layers during manufacturing, and particularly during high-temperature annealing steps which must occur to diffuse implanted ions within active regions. Further, when completed, semiconductors are subjected to high-temperature environments, such as in the aerospace industry, FeRAM and DRAM semiconductors constructed by conventional methods may fail. Previous work in this field has been conducted and reported in the following publications:
Yoon *et al., Investigation of Pt*/*Ta diffusion barrier using hybrid conductive oxide (RuO*_{*3*}*) for high temperature applications*. J. Vac. Sci. Technol. B 16(3), May/Jun 1998, p.1137.
Yoon *et al., Oxidation resistance of tantalum-ruthenium dioxide diffusion barrier for memory capacitor bottom electrodes*, Apply. Phys. Let. V 73, 1998, p. 324.
Yoon *et al., Oxide (CeO*_{*3*}*) incorporated new diffusion barrier for Cu metallization*, Conference Proceeding USLI XIII, 1998 Materials Research Society, 1998, p. 103
Kwak *et al*., *Improvement of Ta diffusion barrier performance in Cu metallization* *by insertion of a thin Zr layer into Ta film,* Apply. Phys. Let. 1998, V72, p. 2832.

### Summary of the Invention

A semiconductor structure includes a substrate taken from the group of substrates consisting of silicon, polysilicon, silicon dioxide and silicon germanium; and an electrode, located above the substrate, which includes a layer of composition Ir-M-O, wherein M is taken from the group of metals consisting of Ta, Ti, Nb, Al, Hf, Zr and V; wherein the semiconductor structure is constructed and arranged to withstand annealing at a temperature greater than or equal to 600°C without losing conductivity and integrity:

A method of forming a semiconductor structure includes preparing a substrate taken from the group of substrates consisting of silicon, polysilicon, silicon dioxide and silicon germanium; depositing successive layers of materials including depositing an electrode layer of composition Ir-M-O, wherein M is taken from the group of metals consisting of Ta, Ti, Nb, Al,Hf, Zr and V; and annealing the semiconductor structure at a temperature greater than or equal to 600°C.

An object of the invention is to provide a bottom electrode or barrier structure on a substrate in a non-volatile memory application wherein the structure can tolerate high-temperature annealing, *i*.*e*., above 600°C, without losing conductivity and integrity.

Another object of the invention is to provide a Ir-M-O layer as an electrode or barrier structure, where M is a metal.

Another object of the invention is to prevent oxidation of a Ta barrier layer by providing a thin metal layer as a second barrier layer between a layer comprised of Ir-Ta-O and a layer of Ta.

A further object of the invention is to prevent oxidation of an Ir-Ta-O electrode by depositing a layer containing Ir, IrO₂, Pt, Ru, or RuO₂ on top of a Ir-Ta-O electrode

Yet another object of the invention is to provide an Ir-Ta-O layer on a substrate taken from the group of substrates consisting of Si, SiO₂, SiGe and polysilicon.

This summary and objectives of the invention are provided to enable quick comprehension of the nature of the invention. A more thorough understanding of the invention may be obtained by reference to the following detailed description of the preferred embodiment of the invention in connection with the drawings.

### Brief Description of the Drawings

Fig. 1 depicts a layering structure of the invention.
Fig. 2 depicts an Ir-Ta-O/gate oxide/Si structure before and after O₂ ambient annealing at 800°C for 10 minutes.
Fig. 3 depicts a gate oxide and Ir-Ta-O structure.
Fig. 4 depicts the C-V of an Ir-Ta-O/gate oxide/Si structure having a 20Å gate oxide.
Fig. 5 depicts the I-V of an Ir-Ta-O/gate oxide/Si structure having a 20Å gate oxide.
Fig. 6 depicts the C-V of an Ir-Ta-O/gate oxide/Si structure having a 35Å gate oxide.
Fig. 7 depicts the I-V of an Ir-Ta-O/gate oxide/Si structure having a 35Å gate oxide.

### Detailed Description of the Preferred Embodiments

The provision of an Iridium-Metal-Oxygen/Metal (Ir-M-O/M) layer as a bottom electrode or barrier structure in non-volatile memory applications has the advantage of being able to withstand temperatures above 600°C, up to 1000°C, without losing its conductivity or integrity, where the metal is taken from the group of metals including tantalum (Ta), titanium (Ti), niobium (Nb), hafnium (Hf), aluminum (Al), zirconium (Zr) and vanadium (V). Further, such a structure is capable of withstanding high operating temperatures once the semiconductor is completed and installed in a real-world system. The oxidation of a M barrier layer may be prevented by inserting a thin M* barrier layer between an Ir-M-O layer and a M layer, *e*.*g*., M may be Ta and M* may be Ir. An Ir-M-O/MO layer, where MO represents the metal oxides, including Ta₂O₅, TiO₂, Nb₂O₅, HfO₂, Al₂O₃, ZrO₂ and V₂O₅, is suitable as a bottom electrode for metal-ferro-insulator-silicon (MFIS) applications. Oxidation of an Ir-M-O electrode may be prevented by depositing a metal layer, such as Ir, IrO₂, Ru, or RuO₂, on top of an Ir-M-O electrode.

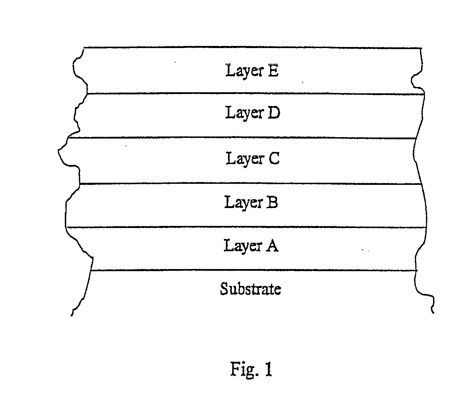

Referring to Fig. 1, the embodiments of the invention include multi-layer structures which are formed on a substrate layer, wherein the substrate may be silicon, polysilicon or silicon-germanium. A MOS structure may be formed on a silicon oxide substrate.

In the first embodiment, the structure includes at least one barrier layer located between the substrate and a Ir-M-O electrode. A first, or bottom, barrier layer, Layer A, is formed on the substrate. Layer A may include Ti or TiN, and provides a conductive layer between the substrate and electrode. A second barrier layer, Layer B, is an optional layer, and may include Ta, TaN, TaSiN, Nb, NbN, AlN, Al-Ti, Al-Ti-N, Hf, HfN, Zr, ZrN, V or VN. The first and the second barrier layers may be deposited on the substrate by CVD, PVD, MOCVD or other thin film deposition methods. Layer A, including Ti, may be deposited on the substrate by DC sputtering in pure Ar, or by any other state of the art deposition technique, at a temperature of between room temperature and about 600°C. The second barrier layer may be deposited by DC sputtering in pure Ar when using Ta, Nb, Zr, Hf or Al-Ti as the metal, or, the second barrier layer may be deposited by reactive sputtering in an Ar-N₂ atmosphere at ambient temperature when using TaN, TaSiN, NbN, AIN, HfN, ZrN or VN as the metal. The total thickness of the first and second barrier layer is preferably between about 10nm and 200nm.

A third, or middle, barrier layer, Layer C, may include Ir, IrO₂, Pt, Ru or RuO₂, or may be formed as a double layer structure of IrO₂/Ir, IrO₂/Pt, RuO₂/Ir, RuO₂/Pt or RuO₂/Ru, having an arrangement of a metal layer on top of a metal oxide layer, or a metal oxide layer on top of a metal layer, on Layer B. Layer C may be deposited by PVD or CVD, MOCVD or other thin film deposition method, and has a thickness of between about 10nm to 300nm.

An electrode layer, Layer D, has the composition Ir-M-O, where M is a metal from the group including Ta, Ti, Nb, Al, Hf, Zr and V, and is formed on the uppermost of barrier Layers A, B or C. Layer D may be formed by PVD, CVD, MOCVD or other thin film deposition methods. The thickness of Layer D is between about 10nm to 500nm. Electrode layer D may be formed by co-sputtering Ir and the metal target at 300W, for four inch diameter targets, on each target at a chamber pressure of about 10mTorr., in an Ar/O₂ flow having a rate of 1:1. An optional fourth,'or top, barrier layer, Layer E, may include Ir, IrO₂, ruthenium (Ru), RuO₂, or platinum (Pt), or may be formed as a double layer structure of IrO₂/Ir, IrO₂/Pt, RuO₂/Ir, RuO₂/Pt or RuO₂/Ru, with the metal layer either above or below the metal oxide layer, on electrode Layer D. Layer E is formed of a low resistivity metal or metal oxide, and may be deposited by PVD, CVD, MOCVD or other thin film deposition methods, with a thickness of between about 10nm to 200nm. A post deposition annealing in an O₂ ambient atmosphere is done at a temperature in a range of between about 600°C and 900°C to stabilize the structure.

The structures described herein may be used as conductive bottom electrode and/or barrier structures on silicon, polysilicon, and silicon germanium substrates in nonvolatile memories, such as MFMS, MFMOS, MFIS, MIFS, and MFS memories, DRAM, capacitors, pyroelectric infrared sensors, optical displays, optical switches, piezoelectric transducers and surface acoustic wave devices. The structures may be formed on silicon oxide substrates to form MOS type devices, such as MFMOS devices.

The conductivity of the electrode layers may be varied by changing the relative metal composition ratio. After deposition of the entire layered structure, an annealing step in an O₂ atmosphere is necessary to lower the resistance of the Ir-M-O film, and to stabilize the structure's thickness. This annealing step may also be performed by annealing in other atmospheres, such as N₂, Ar, or in a vacuum, at temperatures above 600 ° C.

For example, using Ta as M, the as-deposited Ir-Ta-O Layer D, may obtain its lowest resistance by post deposition annealing at 800°C to 900°C in O₂ ambient for between about one to thirty minutes. The thickness of the structure can be stabilized by annealing at a temperature above 600°C.
The steps in the formation process may be summarized as follows:
1. Deposit any Layers A to E at room temperature or higher.
2. Anneal the film at a temperature of between about 600°C to 1000°C to obtain a desired sheet resistance and to stabilize the thickness of the structure.
3. An Ir-M-O layer may be deposited as a bottom electrode without the inclusion of any conducting metal or metal oxide layer on top thereof. The metals of this layer may be taken from the group of metals consisting of Ta, Ti, Zr, Al, Nb, Hf and V.

The second embodiment of the invention uses only four layers, wherein Layers A and B are not used, and includes structures which have an Ir-M-O electrode layer, Layer D, where M is again taken from the group of metals consisting of Ta, Ti, Nb, Al, Hf, Zr and V, and which may be formed without a barrier layer directly on a silicon, polysilicon or silicon-germanium substrate, by CVD, PVD, MOCVD, or any other thin film deposition technique. Layer D has a thickness of between about 10nm and 500nm, when used in FeRAM and DRAM applications. The structure may be formed on a silicon oxide substrate to form a MOS structure. Because a low contact resistance is required between an Ir-M-O bottom electrode and silicon or polysilicon substrates, it is necessary to provide a structure which can maintain low contact resistance during high temperature ambient oxygen annealing processes. The use of an Ir-M-O layer as an electrode on Si, polysilicon and SiGe substrates for FeRAM and DRAM applications provides such a low contact resistance.

An optional barrier layer, Layer C, may include an Ir, IrO₂, Ru, RuO₂, or Pt layer; or may be formed as a double layer structure of IrO₂/Ir, IrO₂/Pt, RuO₂/Ir, RuO₂/Pt or RuO₂/Ru, with the metal layer either above or below the metal oxide layer, and may be deposited on the substrate first before electrode Layer D. Layer C has a preferable thickness of between about 10nm to 300nm, and may be deposited by PVD, CVD, MOCVD, or any other thin film deposition method.

An optional top barrier layer, Layer E, may include Ir, IrO₂, Pt, Ru or RuO₂, or may be formed as a double layer structure of IrO₂/Ir, IrO₂/Pt, RuO₂/Ir, RuO₂/Pt or RuO₂/Ru, with the metal either above or below the metal oxide, and may be deposited on top of the electrode, having a total thickness of between about 10nm to 300nm. The top barrier layer may be deposited by PVD or CVD, MOCVD or other thin film deposition methods. The function of barrier Layer E is to prevent the oxygen diffusion to the substrate. This structure may be used in capacitors, sensors, displays and transducer applications.

As in the first embodiment, the conductivity of the Ir-M-O electrode layers may be varied by changing the relative composition ratio of metal. Post annealing in O₂ is provided to lower the sheet resistivity and to stabilize the thickness of the structure. Post annealing may be performed by annealing in other gases, such as N₂, Ar, or in a vacuum, at temperatures above 600 ° C. For example, an as-deposited Ir-Ta-O layer obtains its lowest resistance by post deposition annealing at 800°C to 900°C in an O₂ ambient atmosphere for one to thirty minutes.

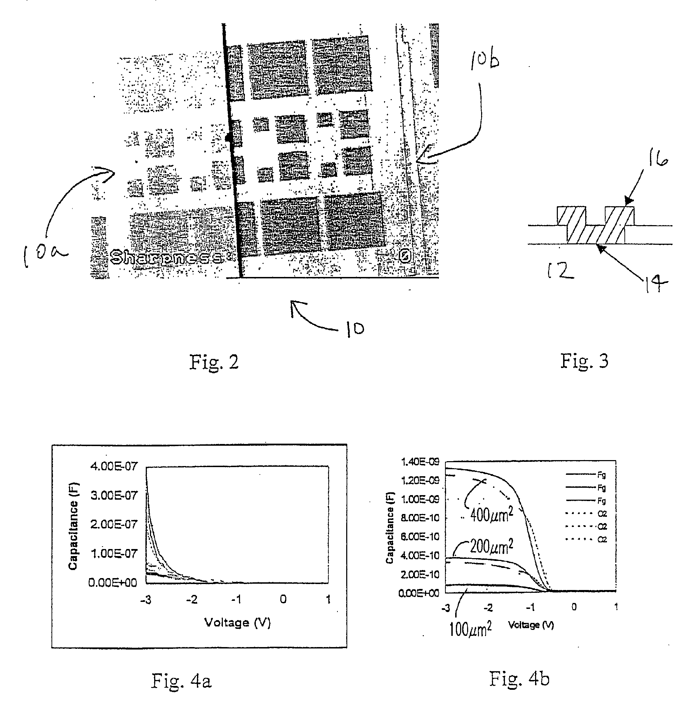

Referring now to Fig. 2, a MOS structure formed according to the invention is shown generally at 10. MOS 10 is constructed by directly depositing Ir-Ta-O electrodes on a gate oxide layer having thickness of 20Å or 35Å. An electrode layer of Ir-Ta-O was formed by cosputtering Ir and Ta four-inch diameter targets at 300W with a chamber pressure of 10 mTorr. in a Ar/O₂ atmosphere at a flow rate ratio of 1:1. A post deposition annealing in O₂ ambient was done at 800°C for ten minutes in order to characterize the thermal stability of these structures.

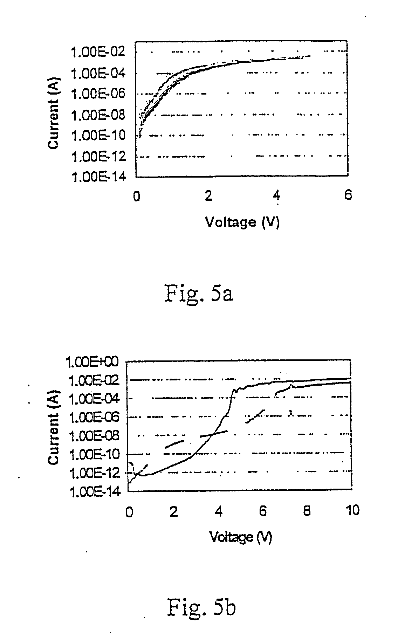

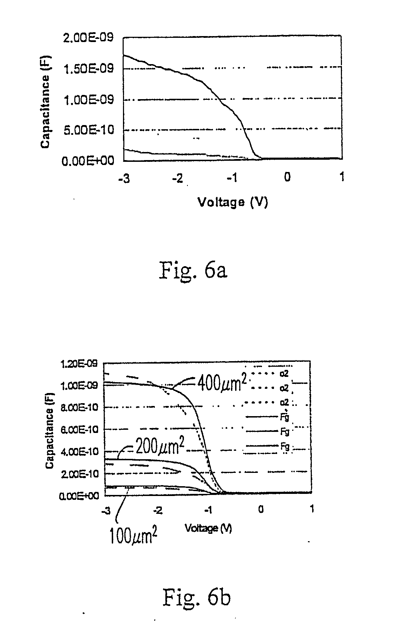

Fig. 2 depicts the Ir-Ta-O/gate oxide/Si structure 10 before (10a) and after (10b) O₂ ambient annealing at 800°C for ten minutes. It can be seen from Fig. 2 that the Ir-Ta-O/gate oxide/Si structure is very stable even after the high-temperature anneal. Hillock and/or peeling were not observed. However, the as-deposited Ir-Ta-O/gate oxide/Si structures with 20Å and 35Å gate oxides were both very leaky. After 800°C oxygen ambient annealing for ten minutes, good C-V characteristics were obtained as shown in Figs. 4b and 6b. The leakage current was significantly reduced. This is due to the interface between Ir-Ta-O and gate oxide was further oxidized during oxygen ambient annealing. The equivalent oxide thickness after annealing is around 40Å to 50Å.

Fig. 3 is a cross-section of MOS structure 10 of Fig. 2, depicting substrate 12, a gate oxide layer 14 and an Ir-Ta-O electrode layer 16.

Fig. 4a depicts the C-V of as-deposited Ir-Ta-O/gate oxide/Si structure of three sizes of capacitors: 400 µm², 200µm² and 100µm², having a 20Å gate oxide; Fig. 4b depicts the C-V of the three structures after annealing at 800°C in O₂ for ten minutes (dashed lines), then annealing in Forming gas at 450°C for fifteen minutes (solid lines).

Fig. 5a depicts the I-V of as-deposited Ir-Ta-O/gate oxide/Si structure of a 100µm² capacitor having a 20Å gate oxide; Fig. 5b depicts the I-V of the structure after annealing at 800°C in O₂ for ten minutes, then annealing in Forming gas at 450°C for fifteen minutes.
Fig. 6a depicts the C-V of as-deposited Ir-Ta-O/gate oxide/Si structure of three sizes of capacitors: 400 µm², 200µm² and 100µm², having a 35Å gate oxide; Fig. 6b depicts the C-V of the three structures after annealing at 800°C in O₂ for ten minutes (dashed lines), then annealing in Forming gas at 450°C for fifteen minutes (solid lines).

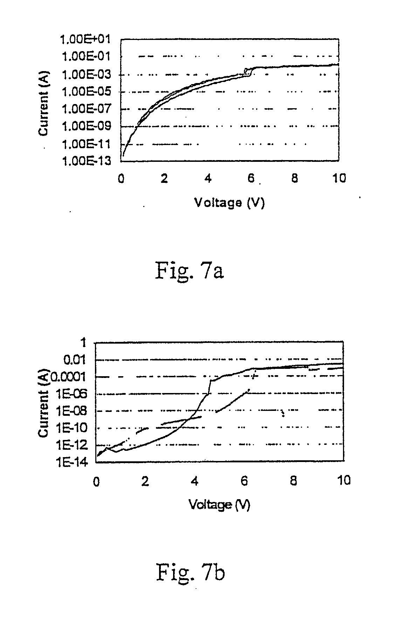

Fig. 7a depicts the I-V of as-deposited Ir-Ta-O/gate oxide/Si structure of a 100 µm² capacitor having a 35Å gate oxide; Fig. 7b depicts the I-V of the structure after annealing at 800°C in O₂ for ten minutes; then annealing in Forming gas at 450°C for fifteen minutes. The C-V characteristics of Figs. 4 and 6 include three sizes of capacitors at: 400 µm², 200µm² and 100µm². The I-V characteristics of Figs 5 and 7 only include 100 µm² capacitors.

The first barrier layer or the second barrier layer, or both, may be applied if further oxidation between a Ir-Ta-O layer and gate oxide layer needs to be minimized. Good contact resistance may be maintained for the Ir-Ta-O/silicon, polysilicon, or silicon germanium structure if the first barrier layer, or the second barrier layer, or both, are used. As used for this part of the description, the first barrier layer and the second barrier layer is a layer of Ir, IrO₂, Ru, RuO₂ and Pt, or a double layer of IrO₂/Ir , IrO₂/Pt, RuO₂/Ir, RuO₂/Pt or RuO₂/Ru, with a metal layer on top of or under a metal oxide layer.

Thus, a high temperature electrode/barrier structure for FeRAM and DRAM applications, and a method for manufacturing same has been disclosed. It will be appreciated that further variations and modifications thereof may be made within the scope of the invention as defined in the appended claims.

## Claims

1. A semiconductor structure comprising:
a substrate taken from the group of substrates consisting of silicon, polysilicon, silicon dioxide and silicon germanium; and
an electrode, located above said substrate, which includes a layer of composition Ir-M-O, wherein M is take from the group of metals consisting of Ta, Ti, Nb, Al, Hf, Zr and V;
wherein the semiconductor structure is constructed and arranged to withstand annealing at a temperature greater than or equal to 600 °C without losing conductivity and integrity.

2. The semiconductor structure of claim 1 which further includes a bottom barrier layer located between said electrode and said substrate, including a layer of material taken from the group of materials consisting of Ti and TiN.

3. The semiconductor structure of claim 1 which further includes a second barrier layer formed between said electrode and said substrate, including a layer of material taken from the group of materials consisting of Ta, TaN, TaSiN, Nb, NbN, AlN, Zr, ZrN, Hf, HfN, Al-Ti and Al-Ti-N.

4. The semiconductor structure of claim 1 which further includes a third barrier layer formed between said electrode and said substrate, including a layer of material taken from the group of materials consisting of IrO₂/Ir, IrO₂/Pt, RuO₂/Ir, RuO₂/Pt and RuO₂/Ru, wherein the third barrier layer comprises a metal oxide layer formed on a metal layer.

5. The semiconductor structure of claim 1 which further includes a third barrier layer formed between said electrode and said substrate, including a layer of material taken from the group of materials consisting of IrO₂/Ir, IrO₂/Pt, RuO₂/Ir, RuO₂/Pt and RuO₂/Ru, wherein the third barrier layer comprises a metal layer formed on a metal oxide layer.

6. The semiconductor structure of claim 1 which further includes a third barrier layer formed between said electrode and said substrate, including a layer of material taken from the group of materials consisting of Ir, IrO₂, Pt, Ru and RuO₂.

7. The semiconductor structure of claim 1 which further includes a top barrier layer formed above said electrode, including a layer of material taken from the group of materials consisting of IrO₂/Ir, IrO₂/Pt, RuO₂/Ir, RuO₂/Pt and RuO₂/Ru, wherein the top barrier layer comprises a metal oxide layer formed on a metal layer.

8. The semiconductor structure of claim 1 which further includes a top barrier layer formed above said electrode, including a layer of material taken from the group of materials consisting of IrO₂/Ir, IrO₂/Pt, RuO₂/Ir, RuO₂/Pt and RuO₂/Ru, wherein the top barrier layer comprises a metal layer formed on a metal oxide layer.

9. The semiconductor structure of claim 1 which further includes a top barrier layer formed above said electrode, including a layer of material taken from the group of materials consisting of Ir, IrO₂, Pt, Ru and RuO₂.

10. The semiconductor structure of claim 1 which includes a layer of oxide located between said electrode and said substrate.

11. The semiconductor structure of claim 1 which includes a conductive layer located between said electrode and said substrate.

12. A method of forming a semiconductor structure comprising:
preparing a substrate taken from the group of substrates consisting of silicon, polysilicon, silicon dioxide and silicon germanium;
depositing successive layers of materials including depositing an electrode layer of composition Ir-M-O, wherein M is taken from the group of metals consisting of Ta, Ti, Nb, Hf, Zr and V; and
annealing the semiconductor structure at a temperature greater than or equal to 600°C.

13. The method claim 12 wherein said depositing includes depositing a first barrier layer of materials taken from the group of materials consisting of Ti and TiN.

14. The method of claim 13 wherein said depositing further includes depositing a second barrier layer between the substrate and the electrode including a layer of material taken from the group of materials consisting of Ta, TaN, TaSiN, Nb, NbN, AlN, Zr, ZrN, Hf, HfN, Al-Ti and Al-Ti-N.

15. The method of claim 14 wherein said depositing includes depositing the first barrier layer and the second barrier layer to a combined thickness in a range of between about 10nm to 200nm.

16. The method of claim 12 wherein said depositing further includes depositing a third barrier layer below the electrode, including depositing a layer of material taken from the group of materials consisting of IrO₂/Ir, IrO₂/Pt, RuO₂/Ir, RuO₂/Pt and RuO₂/Ru, wherein the third barrier layer has an arrangement taken from the group of arrangements consisting of forming a metal oxide layer on a metal layer and forming a metal layer on a metal oxide layer.

17. The method of claim 12 wherein said depositing further includes depositing a third barrier layer below the electrode, including depositing a layer of material taken from the group of materials consisting of Ir, IrO₂, Pt, Ru and RuO.

18. The method of claim 12 wherein said depositing further includes depositing a top barrier layer above the electrode, including depositing a layer of material taken from the group of materials consisting of IrO₂/Ir, IrO₂/Pt, RuO₂/Ir, RuO₂/Pt and RuO₂/Ru, wherein the top barrier layer has an arrangement taken from the group of arrangements consisting of forming a metal oxide layer on a metal layer and forming a metal layer on a metal oxide layer.

19. The method of claim 12 wherein said depositing further includes depositing a top barrier layer above the electrode, including depositing a layer of material taken from the group of materials consisting of Ir, IrO₂, Pt, Ru and RuO.

20. The method of claim 10 wherein said depositing includes depositing an electrode layer and simultaneously forming an oxide layer between the electrode and the substrate.

21. The method of claim 10 wherein said depositing includes depositing a conductive layer on said substrate.
